(19) 

**Europäisches Patentamt**
**European Patent Office**
**Office européen des brevets**

(11) **EP 4 436 910 B1**

(12) **EUROPEAN PATENT SPECIFICATION**

(45) Date of publication and mention
of the grant of the patent:
**13.08.2025 Bulletin 2025/33**

(21) Application number: **22829842.8**

(22) Date of filing: **23.11.2022**

(51) International Patent Classification (IPC):
**B81B 3/00** *(2006.01)*      **H02N 1/00** *(2006.01)*

(52) Cooperative Patent Classification (CPC):
**B81B 3/0037; H02N 1/006;** B81B 2201/12;
B81B 2203/0109; B81B 2203/053

(86) International application number:
**PCT/IB2022/061325**

(87) International publication number:
**WO 2023/095014 (01.06.2023 Gazette 2023/22)**

(54) **ELECTROSTATICALLY-EXCITED HERMETIC MULTI-CELL MICROELECTROMECHANICAL ACTUATOR AND PRODUCTION METHOD THEREOF**

ELEKTROSTATISCH ERREGTER HERMETISCHER MEHRZELLIGER MIKROELEKTROMECHANISCHER AKTUATOR UND HERSTELLUNGSVERFAHREN DAFÜR

ACTIONNEUR MICROÉLECTROMÉCANIQUE À CELLULES MULTIPLES HERMÉTIQUE EXCITÉ ÉLECTROSTATIQUEMENT ET SON PROCÉDÉ DE PRODUCTION

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **26.11.2021 LT 2021572**

(43) Date of publication of application:
**02.10.2024 Bulletin 2024/40**

(73) Proprietor: **Kaunas University of Technology 44249 Kaunas (LT)**

(72) Inventors:
• **VIRZONIS, Darius**
  **35144 Panevezys (LT)**

• **VANAGAS, Gailius**
  **36236 Panevezys (LT)**
• **DZIKARAS, Mindaugas**
  **35193 Panevezys (LT)**
• **BARAUSKAS, Dovydas**
  **37123 Panevezys (LT)**
• **PELENIS, Donatas**
  **35193 Panevezys (LT)**
• **MIKOLAJUNAS, Marius**
  **37304 Panevezys (LT)**

(74) Representative: **AAA Law A. Gostauto 40B 03163 Vilnius (LT)**

(56) References cited:
**US-A1- 2016 023 244**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

Processed by Luminess, 75001 PARIS (FR)

**Description**

FIELD OF INVENTION

This invention discloses a structure and production method of an electrostatically-excited microelectromechanical actuator. The actuator's structure is hermetically sealed by perimeter, and it comprises a set of asymmetric electrostatic-capacitive hermetic cells, which, when excited electrostatically, create a torque relative to the actuator base, variously and efficiently deforming the base in the vertical direction. The actuator is applicable as an atomic force microscopy (AFM) sensor and in control of microfluidics.

BACKGROUND ART

One of applications of the present invention is atomic-force-microscopy (AFM), which is a subclass of scanning-probe-microscopy (SPM). The purpose of SPM is to obtain a three-dimensional nanoresolution image of the object under study. The specifics of AFM application is the registration and measurement of interatomic forces acting as a function of the distance between the object under study and the AFM sensor.

The mechanical part of a typical AFM sensor comprises of a cantilever-shaped sensitive element, the free-end of which has a tip tapered to nanometer dimensions, while the anchored-end of said cantilever is excited by a coupled electromechanical system. The displacement of the free-end of the cantilever is sensed and recorded by an optical sensor, as disclosed in the patent US4724318A by IBM. However, this classic AFM sensor has significant performance limitations due to the relatively low excitation frequency, optical scan delay, and sequential method of scanned image acquisition. To increase the AFM performance, the authors of the document **[1, 2]** have proposed to employ several or several tens of parallel AFM channels for image formation. Further research on parallel AFMs has demonstrated several opportunities for AFM sensors based on arrays of chips **[4, 5, 10]**. However, these solutions reduced the resolution of AFM and created new performance limitations related to the technical problems of processing large amounts of parallel data.

In recent years, the concept of an AFM sensor with no cantilevers has been dislosed, based on a three-dimensional nanoprinted array of AFM probes [7], registering displacements using the principle of distributed optical leverage [3]. This device demonstrated the parallel operation of 1000 individual sensors operating in a 0.5 mm aperture. However, the resulting resolution appeared far behind of modern AFM capabilities. Another way to improve AFM performance is to increase the excitation frequency. In order to increase the excitation frequency, it is proposed to integrate capacitive micro-mounted ultrasonic transducers (CMUT) into the AFM sensor cantilever. A cantilever-type element operating at a frequency of 1.76 MHz in air was demonstrated, but only its radiation pressure was measured, without AFM operation [6]. A few years later, a combined AFM sensor containing a CMUT element with a nanometer-sized tip in the classic AFM probe-type sensor has been developed and disclosed [11], (US7395698B2, WO2008052065A2, Georgia Tech Research Corp). This device (FIRAT) used an electrostatically excited and optically readable CMUT-type or microbridge-type cell with a nanometer-sized tip in the center. This microstructure was integrated into the free-end of the AFM probe of conventional dimensions, and it has exceeded significantly the performance and dynamic sensitivity technical capabilities of known devices. Also, this device made possible to quantify interatomic forces. However, the FIRAT structure was too complex, expensive to manufacture, and the vertical range (along z-axis) of AFM operation remained limited by the vacuum gap size of the CMUT structure. Also, in this sensor, it was impossible to resolve the contradictions between the mass of the stylus (tip) integrated on the CMUT membrane and the need to increase the overall sensitivity and dynamic range of the device along the vertical axis.

One more improvement of the electrostatically excited AFM sensor was disclosed in the US Patent US7797757B2 (Georgia Tech Research Corp). The main objective technical problem of the invention was the limitation of performance due to the previously used principle of external excitation of the AFM cantilever. This invention describes several embodiments of electrostatic excitation that at least partially solve the problem of the vertical axis limitation inherent by electrostatic devices. The actual length of the vertical axis here depends not only on the gap size of the electrostatic device, but also on the length of the cantilever element. However, when attached to the cantilever structure, it practically works only in the resonant mode, since static modes in large z-axis sections are associated with high operating voltages, and the risk of entering the well-known snap-in (collapse) mode. Also, the solutions proposed in this patent rely to the optical reading of the displacement of the sensor, therefore, the probes had to be made of a transparent material, which increased the complexity and cost of the sensor.

Recently, a new type of electrostatic actuators was disclosed, in which electrostatic force causing tensile or compressive stresses in the transverse direction has been used to deform various structures, as disclosed in the US patent US9164277B2, by Fraunhofer Gesellschaft zur Förderung der Angewandten Forschung eV [12]. This invention reveals how transverse stresses are employed to induce bending forces in various microstructures (micro-cantilevers, microbridges, and micromembranes). This invention is a significant step in the field of microelectrostatic devices, enabling to decouple electrostatic gap-related structural limitations from the maximal operating range of the microstructure along the vertical axis.

It should be noted that the discussed technical solutions improving AFM sensors and using electrostatic excitation are related to the design and manufacturing technology of capacitive micromachined ultrasonic transducers (CMUT) disclosed in Stanford university's 1998 year patent US5982709. This transducer comprises membranes of a chosen size and shape, supported at their edges by supports, where many membranes are placed next to each other, the first electrode is the base for fixing the membranes, and the second electrode is a thin layer of a conductor covering the surface of the membranes. The membrane supports form cavities under the membranes and channels between these cavities, so the membrane cells are not hermetic in relation to each other.

However, in the mentioned invention by Fraunhofer Gesellschaft US9164277B2, and in many other known designs, AFM sensors or electrostatically excited micro-electromechanical structures of other purposes, having a relatively large displacement travel (greater than 1 μm) did not use deformable elements being fixed around the entire perimeter. Those would be an advantage for achieving larger working frequencies and higher working energies of the AFM sensor, related to higher equivalent stiffness of deformable elements.

Also, the perimetric mounting of the deformable elements inherently provides hermetic properties, therefore, the structures based on such elements are less sensitive to contamination and less damped during operation, for example, when the AFM sensor works in liquids. Also, hermeticity is an essential property of such electrostatic actuator, when employing it in microfluidic control systems.

A further document US 2016/023244 A1 shows an electrostatic transducer comprising a membrane, a plate-shaped element and supporting elements.

SUMMARY OF INVENTION

This invention discloses a micro-electromechanical actuator, as claimed in claim 1, distinguished by the following special constructional features:

- the electrostatically-excitable plate is mounted hermetically by its entire perimeter onto the actuator's stationary base,
- said plate comprises a microstructure consisting of many asymmetrical electrostatic-capacitive cells, which, when being electrostatically-excited, create local torques in this multi-cellular structure.

Such structure being fixed by perimeter, when electrostatically excited, is deformed in the vertical direction in the range of several to tens of micrometers, in a variety of static and dynamic ways. These properties allow to use it for scanning-probe microscopy operating in static and/or dynamic modes. For example, one of the application fields of this actuator is atomic force microscopy (AFM), where an individual such actuator can act as a single AFM sensor, or several such actuators - as a one-dimensional or two-dimensional array of parallel AFM sensors, forming a three-dimensional nanoscale image. Another possible application of this hermetic actuator is a flow controller for microfluidic systems.

The invention also discloses a production technology of this fixed-by-perimeter plate structure with integrated asymmetric capacitive cells, as claimed in claim 12, by employing the principle of wafer bonding.

The micro-electromechanical actuator has advantages by the following **technical effects:**

- when using electrostatic excitation, a wide range of operating frequencies and low resonance quality is obtained;
- in AFM applications, using an array of actuators as AFM sensors provides high AFM scanning performance and wide field of view;
- an optical sub-system for scanning AFM sensors can be integrated inside the perimetrically-fixed actuator; thus, obtained a simple and efficient design of the electromechanical part of the actuator, as well as a minimal dependence of the signal reading quality on environmental conditions;
- the sensor comprises a hermetically sealed membrane with a microstructure of capacitive-electrostatic cells, which is easily maintained; in liquids, it is less damped than conventional cantilever-type AFM sensors; it has a higher equivalent stiffness potential, therefore, can operate at higher frequencies.
- the perimetrically-anchored membrane with electrostatic cells can be directly integrated with AFM scanning electronics. This eliminates the measured signal's mechanical and electrical transitions, which limit using conventional AFM sensors. Also, direct integration of the sensor with the AFM electronics reduces the cost of the AFM.
- the range of vertical displacement (z-axis) of the actuator surface is not limited by the size of the vacuum gap of the electrostatic cells; the limits of the vertical travel of the actuator can be expanded or narrowed by changing dimensions of the actuator's structural elements, but not changing the excitation voltage range.
- using this actuator as an AFM sensor, it enables a rotary motion of an individual AFM probe, resulting in higher resolution, new AFM scan modes, and more accurate 3D-imaging.

DESCRIPTION OF DRAWINGS

The essential aspects of the invention are explained by the drawings and diagrams. The drawings and diagrams are an integral part of the invention description and provided as a reference to possible implementations or visual explanations of the invention, but should not limit the scope of the invention. The drawings are schematic and principal, while the sizes, proportions and specific implementation options of the objects depicted may differ within the scope of the invention.

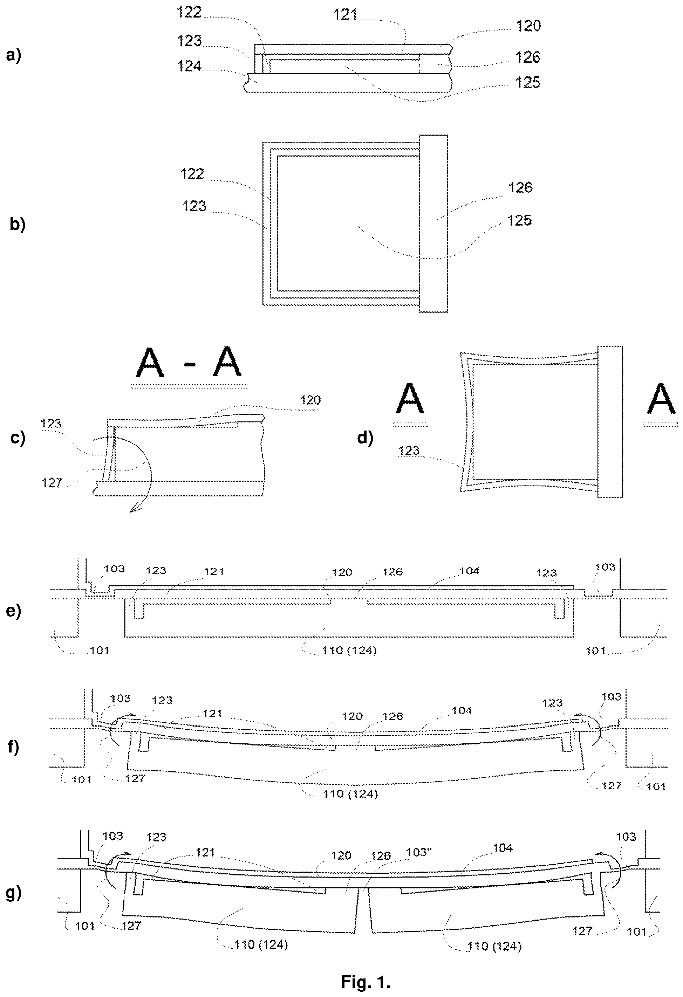

**Fig. 1** the structure of a micro-electromechanical actuator comprising asymmetric capacitive cells:

**a)** the vertical section of the asymmetric capacitive cell which is the actuator's base element; and
**b)** the top view without cell membrane: 120 - cell membrane, 121 - vacuum gap, 122 - vertical gap, 123 - vertical support, 124 - base, 125 - lower electrode, 126 - anchor support;
**c)** depicts the capacitive cell in the deformed state under the action of the Coulomb force: vertical section A-A of the cell; and
**d)** top view of the cell without the membrane 120; where the membrane 120 deforms by bending downward, and the vertical support 123 bends under the influence of the deformed membrane 120 - such deformation of the vertical support 123 creates a torque 127;
**e)** depicts a vertical section of the construction of the actuator comprising at least two capacitive cells: 101 - stationary base for anchoring the actuator; 103 - spring elements (here, implemented as thinnings of the actuator structure in the perimeter of the anchoring); 104 - upper electrode, common to both cells; 110 - the movable base of the actuator, coinciding with the base of the asymmetric capacitive cells 124; 120 - common membrane for both cells; 121 - vacuum gap in the cell; 123 - vertical support; 126 - anchor support, common to both cells;
**f)** depicts the actuator comprising at least two asymmetric capacitive cells arranged symmetrically with respect to the central axis of the actuator device, in a deformed state under the action of the Coulomb force, wherein: the membrane 120 is attracted in the capacitive cells, therefore, in the interaction of the vertical supports 123 with the membrane 120, torques 127 are created in opposite directions - when for these moments, the movable base 110 of the actuator deforms, creating a vertical displacement in the central part of the actuator greater than the height of the vacuum gap 121 in the undeformed position of the capacitive cells;
**g)** an embodiment of the actuator, in which to achieve greater vertical travel, lower equivalent elasticity and lower operating frequency, an additional spring element is created in the central part of the actuator, in this embodiment, a recess 103" in the base 110 of the actuator.

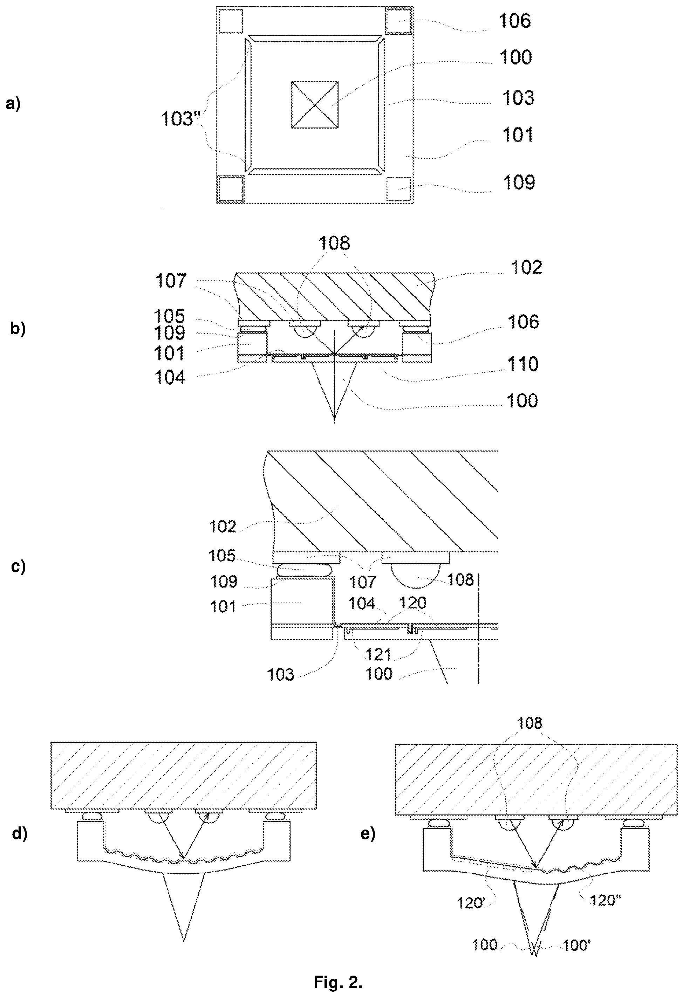

**Fig. 2** A one-element AFM sensor implemented on the basis of the actuator:

**a)** bottom-view of the AFM sensor: 100 - AFM tip; 101 - stationary structural anchoring base; 103 - recess separating the moving part of the actuator from the stationary base; 103" - deepening breaks in the corners of the device; 106 - contact area of the lower electrode; 109 - contact area of the upper electrode;
**b)** structure of the AFM sensor, vertical section: 102 - printed circuit board; 104 - the upper electrode of the electrostatic cell; 105 - solder ball; 107 - conductors of printed assembly; 108 - elements of the optical scanning system; 109 - contact area; 110 - the moving base of the actuator;
**c)** structure of the AFM sensor, vertical section to symmetry axis of the sensor, and additionally marked elements: 120 - upper plates of electrostatic cells; 121 - vacuum gaps of electrostatic cells;
**d)** vertical section of the AFM sensor when all cells are excited simultaneously;
**e)** vertical section of the AFM sensor's element, when only a portion of the cells are excited at a time, thus creating an asymmetric deflection of the moving base 110 and a corresponding rotational movement of the AFM tip 100.

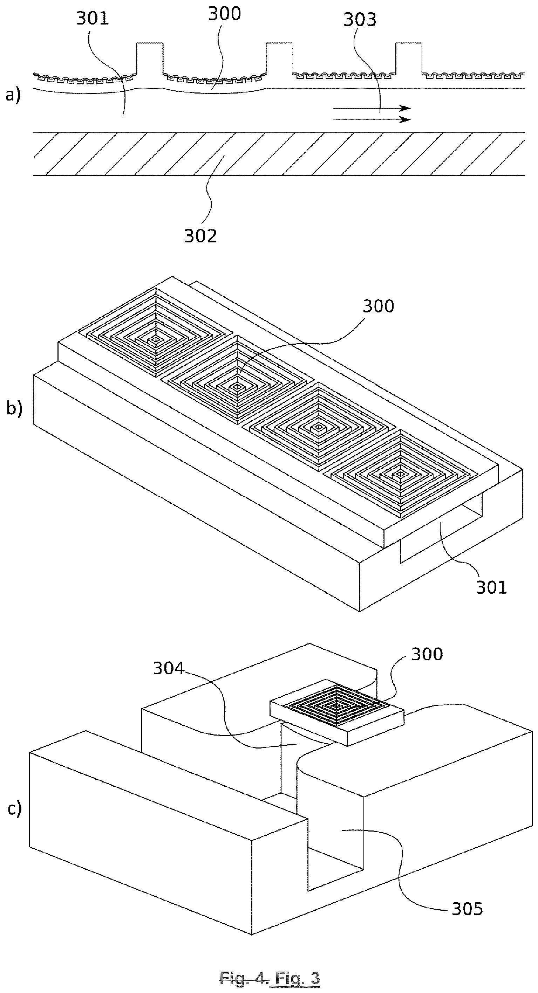

**Fig. 3** depicts an application, in which an array of actuators 300 is used to control microfluidic flow 303:

**a)** by activating actuators of the array 300 at different time moments, peristaltic pumping of liquid is carried-out through the microchannel 301 in a selected direction (marked by arrows - 303); 302 - the bottom of the microchannel;
**b)** a microfluidic channel portion 301 with a peristaltic pump comprising an array of actuators 300; peristaltic pump actuators 300 are shown without the upper printed mounting plate connecting them;
**c)** application of the actuator performing the function of the microfluidic valve: 304 - microchannel partition with reduced cross-sectional area of the microchannel branch; 300 - actuator; 305 - main microchannel;

**Fig**. **4** Arrays of AFM sensor elements:

a) cross-section of the one-dimensional array of AFM sensor elements; 100 - AFM tips; 101 - stationary base of the device; 202 - an optically transparent printed assembly plate on which the array of AFM sensor elements is assembled; 203 - capacitive cells; 104 - the upper electrode of the sensor element; 105 - solder balls; 106 - contact areas; 107 - conductors on a printed circuit board; 208 - optical system for reading the state of the AFM sensor; and leads of the optical system;

b) application of the invention, in which the AFM sensor is implemented as a two-dimensional array of AFM actuators; 200 - an individual actuator in the array; 101 - the stationary base of the actuators; 100 - AFM tips.

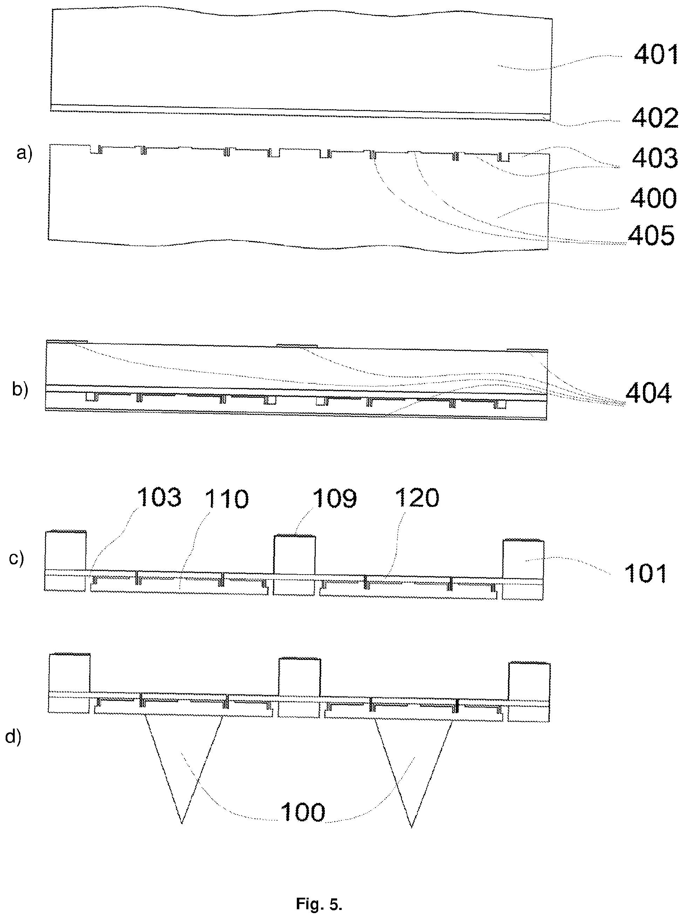

**Fig. 5** depicts the AFM sensor production technology:

a) two silicon wafers are prepared: 400 - a monocrystalline silicon wafer with the sub-membrane cavities 403, and 401 - a monocrystalline silicon wafer with the silicon on isolator (SOI) structure 402;

b) wafers are bonded by direct silicon/silicon oxide fusion and thinned on both sides; 404 - protective mask of silicon nitride, prepared by thin-layer deposition, lithography and etching methods after bonding and thinning the wafers;

c) after removal of the plate's parts not protected by the mask, the membranes 120 of the electrostatic cells are released, and after additional lithography operations, the cells are separated in the necessary places. The masked portions of the wafer form the stationary base of the sensor device 101. After releasing the membranes, if required by the logic of the electrical connections, the exposed silicon may be further oxidized with a thin layer of silicon oxide. Electrostatic cell membranes 120 can be metallized by deposition and lithographic processing of a thin metal layer, thus forming the necessary network of conductors and upper electrodes and contact areas 109. In the lower part of the device (according to the figure), the moving base 110 is separated by lithography and deep etching methods, thereby, forming the spring-structures 103.

d) the group of AFM tips 100 is formed by additive fabrication, such as 3D-nanoprinting, two-photonic polymerization, and others. Also, AFM contacts can be formed on the wafer 400 during its thinning, by selecting appropriate deep reactive etching method and lithographically forming the necessary etching masks.

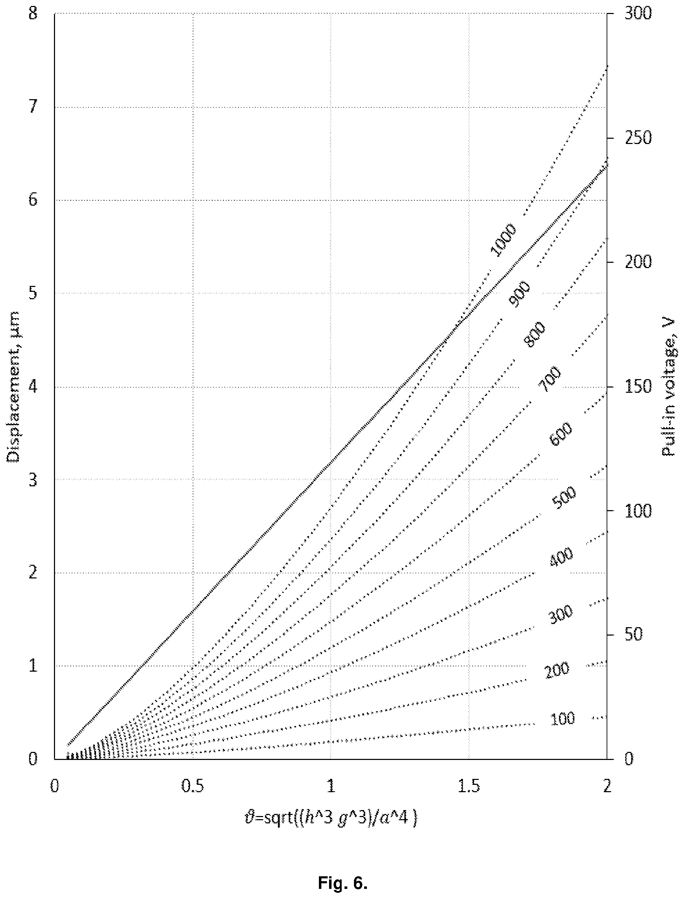

**Fig. 6** illustrates the displacement of the central point of the perimeter-anchored AFM sensor element structure in the vertical direction, in case of a static excitation. Different curves are associated with different transverse dimensions of the perimeter-anchored structure.

## DETAILED DESCRIPTION OF INVENTION

**Construction and operation of the actuator.** The invention comprises an electrostatically excited perimetrically-anchored and hermetically sealed plate structure comprising a plurality of asymmetric electrostatic capacitive cells formed on one of the plate surfaces. During excitation of the actuator, a vertical deflection of the perimeter-fixed plate is created, resulting from the sum of the local torques generated by many non-symmetrical cells. The operation of the basic element of the actuator - the electrostatic-capacitive cell - is illustrated in Figure 1. - Figures 1a-b show the basic structure of a capacitive cell: a) cross-section of the capacitive cell, b) top view of the cell structure after removing the membrane 120. The most important parts of the electrostatic-capacitive cell are the membrane 120, which is mechanically and hermetically anchored along its entire perimeter to the vertical support 123 and the anchor support 126, the lower electrode 125 and the vacuum gap 122. The upper electrode of the capacitive cell can be combined with the membrane 120 (if the membrane is made of an electrically-conductive material) or formed on the surface of the membrane if the membrane is made of a dielectric material. If the membrane 120 is made of an electrically-conductive material, it must be electrically isolated from the vertical support 123 and the anchor support 126 which support the membrane. In Figures 1 and 2, the mechanical base 124 of a single capacitive cell forms an integral part of the actuator moving base 110, in other words, the actuator's moving base 110 comprises integrally connected moving bases 124 of multiple capacitive cells. A special feature of this cell design is that the vacuum gap 122 has horizontal and vertical segments allowing deformation of the support 123 with torque 127 (as shown in Figure 1c). A cross-section of a capacitive cell with membrane 120 attracted by an electrostatic force is shown here. Figure 1d shows the A-A position of the cross-section and the top view of the capacitive cell without the membrane, during electrostatic attraction. When the deformation of the vertical support 123 occurs, a torque 127 is transmitted to the base 124 of the cell, which deforms the base 124 or another structural element associated with the asymmetric electrostatic cell, as shown in Figure 2. The size and direction of the torque 127, and at the same time, the size of the deformation caused by the base 124 or another structural element created by one cell, depends on: the dimensions and proportions of the cell elements, the way how several cells are interconnected, and properties of materials from which the elements of the entire structure are made. These parameters are selected and optimized during the design of the actuator, according to the intended purpose characteristics of the actuator.

The arrangement of non-symmetrical cells in the actuator plane can be: symmetric with respect to the selected symmetry axis or center of symmetry, non-symmetrical, circular, and various other options. The arrangement of cells is chosen during the design of the actuator, is subject to optimization, and depends on the purposive characteristics of the actuator. Figures 2b and 2c show the case of the AFM sensor, where a symmetrical orientation of the capacitive cells with respect to the central axis of the actuator has been chosen. Cells to the left from the axis of symmetry are oriented so that anchor support 126 is oriented to the right, and cells to the right of the axis of symmetry have their anchor support 126 oriented to the left. Such an orientation of the cells means that the torques 127 created by the cells on the opposite sides of the axis of symmetry will be opposite and will combine in the central part of the actuator's moving base 110, where the AFM tip 100 is located. In this way, the maximum deformation of the central part of the moving base 110 in the vertical direction occurs.

Figure 2 a shows a view of the actuator-based AFM sensor from the side of the AFM tip 100. The stationary base of the device 101 is separated from the moving base 110 by recesses 103 which have breaks in the corners 103". The corner-breaks improve the mechanical stability of the actuator device and are used for electrical connections to the contact pads 109 (for connecting the upper electrode) and 106 (for connecting the lower electrode) on the stationary base 101. The recess 103 (Figures 2 b-c) terminates in the membrane of the capacitive cells, ensuring the hermeticity of the perimetrical attachment. The purpose of the recess 103 is to create the necessary elasticity around the perimeter of the moving base 110. The design and shape of recess 103 can be varied. The design and optimization of the shape of recess 103 and its cross-sectional profile is selected/defined during the construction of a specific actuator's device. Figures 2 b-c also show a method of assembling the actuator onto the printed circuit board 102. The printed circuit board has a set of conductors 107 that are used to electrically and mechanically connect the actuator to the AFM electronics using solder balls 105. Also, the printed circuit board can be equipped with an actuator's deformation optical scanning system 108 that measures light reflection from the actuator's top electrode 104. Other methods of reading the AFM signal, such as measuring electrical capacitance can also be used.

Figure 6 shows a diagram of the static vertical center point displacement of actuators having various dimensions when the capacitive cells are in the pull-in (collapse) mode. Different curves correspond to different transverse dimensions of the perimeter-anchored actuator's structure. The horizontal axis of the diagram plots the nonlinear parameter $\vartheta$ of the capacitive cells, which is linearly related to the collapse voltage. This parameter estimates the the relationship between the critical dimensions of a capacitive cell: membrane thickness $h$, membrane side length $a$, and gap $g$:

$$\vartheta = \sqrt{\frac{h^3 g^3}{a^4}}. \qquad (12)$$

The solid line represents the collapse voltage, along the right vertical axis. Displacements are shown for 15 $\mu$m thick (here, "thickness" is the thickness of the moving base 110, not taking into account thickness of the spring structures 103) for square-shaped actuators, having side lenght from 100 $\mu$m to 1000 $\mu$m (here, "side" is the side of the moving base 110 according to Figure 1b). The side length is indicated by numbers crossing the corresponding lines showing the deflections of the central point of the structure. Accordingly, the number of capacitive cells fitting into one row is varied from 14 to 26 according to the actuator's structure's side length, to cover the range of critical cell dimensions. From the diagram in Figure 6, it is evident that perimeter-anchored structures can be used to achieve relatively large (of several micrometers) static displacements by using relatively low voltages (up to 200V). After proper optimization of the dimensions of the capacitive cells and the moving base 110, it is possible (under adequate conditions) to achieve vertical displacements of the moving base 110 of up to 20$\mu$m, which correspond to AFM sensors' usual deflection range in the vertical direction when the AFM sensor operates in static mode. The actuator can also be excited with dynamic modes used in practical AFM applications. Actuator structures with higher equivalent stiffness can be useful in AFM applications where high excitation frequencies and AFM speed are important, while thinner ones applicable where higher static sensitivity and resolution are important.

**Applications of the actuator. Single-channel AFM sensor.** One possible application of the actuator is shown in Figure 2. The design of a single-channel AFM sensor with an integrated optical scanning system is shown here. AFM tip 100 is formed on the outer side of actuator's movable base 110. The movable base 110 may be made of an electrically conductive material with a relatively high modulus of elasticity, such as highly-doped monocrystalline silicon or other suitable material. The movable base 110 of the actuator is connected through the spring structure 103 to the mechanical strength-providing part in the periphery 101, which is named the stationary (immovable) base. Appropriate number of asymmetric electrostatic cells is formed on the inner side (the upper side, in Figures 2 b-c) of the movable base 110. Membranes 120 of asymmetric electrostatic cells are electrically isolated from the movable base 110 and, together with the supporting elements 123 and 126, form hermetic vacuum cavities. The lower electrode 125 is integrated with movable base 110, which is electrically and mechanically common to all electrostatic cells. The upper electrode 104 may be common to all electrostatic cells, or there may be several upper electrodes grouping the electrostatic cells into functional groups. The structure of the capacitive cells used to illustrate the single-channel AFM actuator is completely analogous to the structure shown in detail in Figure 1, and their operation corresponds to the explanation in the "Construction and operation of the actuator" section of the description of the present invention. The lower electrode is electrically connected to the contact pad 106, and the upper electrode (or electrodes) are connected to one or more connection pads 109, which are electrically isolated from the base 101. The actuator is electrically and mechanically connected directly to the printed circuit board 102, which carries and contains the necessary electronic components by using solder balls 105. The carrier printed circuit board 102 also has electrical conductors 107 used to connect the sensor to the signal processing electronics. The carrier printed circuit board 102 is mechanically connected to the electromechanical positioner of the microscope, and electrically to the signal processing electronics. Both of the latter assemblies may be standard AFM assemblies, therefore, not the subject of the present invention. The optical scanning system 108 is also mounted onto the conductors of the carrier printed circuit board 102 by soldering. It emits light and reads the reflection from the upper surface of the electrostatic cells 104. The intensity of the reflection is modulated by the movement of the movable base 110. The practical transverse dimensions of this integrated AFM sensor (not counting the dimensions of the printed assembly board 102) can reach from one to several millimeters. Figure 2c presents more detailed view of the cross-section shown in Figure 2b, providing more visible elements of the microstructure: the spring structure 103, the membranes 120 of the electrostatic cells, and the vacuum gaps 121 of these cells.

Figure 2d illustrates the case where all capacitive cells of the AFM sensor are operating simultaneously, and the cross-section shows the symmetrical base deflection. In this case, all the electrostatic cells are subjected to the electrostatic force caused by the electric charge between the upper electrodes and the lower electrodes, and act together to deform the movable base 110, as explained in detail in the previous section of the description of the present invention. Thus the AFM tip 100 mounted on the actuator's movable base will move straight down. The practical range of the vertical movement of the tip will depend on the selected dimensions of the structure and the properties of the materials from which the structure is made.

Figure 2e shows the vertical cross-section of the AFM sensor in the case of asymmetric deflection. In this case, the right (according to the figure) group of capacitive cells is actuated by electrostatic force. On one side of the base, the torques produced by the group of cells will cause an asymmetric deformation of the moving base, and the tip 100 will be rotated to the left, as shown in the figure. The dotted line of the AFM tip 100' indicates a strictly vertical (with no rotation) movement of the AFM sensor tip. Figure 2e depicts the case where only a half of the electrostatic cells are active, causing the structure to deform asymmetrically, giving the tip 100 additional rotational motion. The ability to provide additional rotary motion to the tip is a unique feature of an embodiment of the present invention that can be employed to create modified scanning modes and achieve higher three-dimensional AFM resolution.

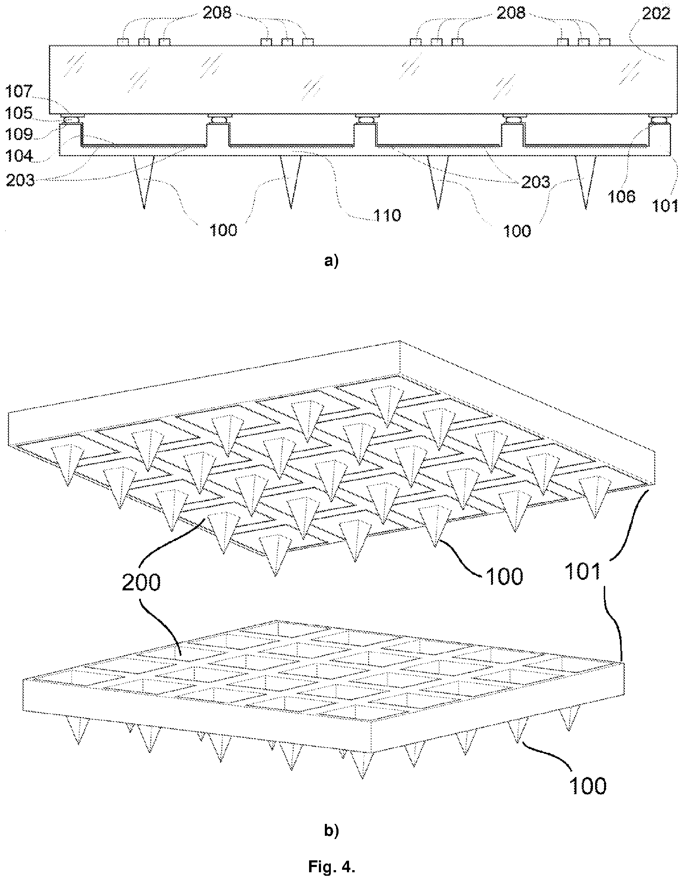

**Multi-channel AFM sensor.** Another application example is a one-dimensional or two-dimensional AFM sensor comprising an array of integrated actuator structures equivalent to the previously explained one-channel AFM sensor. A cross-section of an AFM sensor array with four tips 100 is shown in Figure 4a. The number of tips may vary depending on a specific application. The concept shown in Figure 4a also applies to the matrix type (two-dimensional) AFM sensor configuration shown in Figure 4b. In both the one-dimensional and two-dimensional arrays of AFM sensors, the tip 100 of each AFM sensor can be individually electrostatically excited by a number of electrostatic cells 203. The electrostatic cells 203 are connected to the moving base 110 of the AFM sensors, in the same way, as in the case of the single actuator shown in Figure 1. In Figure 4a, the electrostatic cell 203 comprises the structural elements shown in Figure 1: the top-electrode 104, the membrane 120, the vacuum gap 121, and the movable base 110. The stationary base 101 of the device is equivalent to the corresponding structure shown in Figure 1. The electrostatic cells 203 are excited by the upper electrodes 104, which are electrically isolated from the movable base 110, have a reflective surface, and are connected to the external electronics through the contact pads 109. The lower electrode is integrated with the movable base 110, and is connected to the external control electronics through the contact pad 106. The entire actuator is soldered with the solder balls 105 to an optically transparent holding plate 202, on which a one-dimensional or two-dimensional array of optical scanning elements 208 is installed. A suitable implementation option for the optical scanning system is a number of optical pairs consisting of a light (laser) diode and a photodiode, which corresponds to the number of AFM sensors in the array. Another possible implementation option: a high-speed CMOS image sensor with side-illuminating elements. The supporting plate 202 includes a network of conductors 107 connecting the elements of the multi-channel AFM sensor to the external control electronics. The practical dimensions of individual AFM sensor elements of the array can match the field-of-view dimensions of a conventional single-channel AFM. For example, the distance between adjacent AFM tips 200 may be in the range of 100-200 $\mu$m. In this way, the data obtained by several AFM sensors during the normal scanning process are combined into a high-quality large field of view (in the described example with a 4x4 AFM sensor matrix, the field of view is from 400x400 $\mu$m to 800x800 $\mu$m, respectively). A larger field-of-view allows expanding the application possibilities of AFM and is improving the data acquisition rate from larger areas under investigation by AFM. In the range of the abovementioned dimensions, the resonant operation mode of the AFM sensor is more efficient. The practical resonant frequency range is from 1 to 2 MHz.

Figure 4b shows another example of application of the invention, in which the multi-channel AFM sensor is implemented on the basis of a two-dimensional array (matrix) of actuators and has a two-dimensional array of AFM tips 100. The device's stationary base 101, as in the case of the one-dimensional array shown in Figure 4a, is the common base for all actuators 200 of the array. The microstructure of a single actuator 200 in the array is equivalent to microstructurs of the actuator elements shown in the other figures.

**Microfluidic controller.** Another example of the use of the actuator is the control of liquid flows in microfluidic devices. This example is illustrated in Figure 3.

Figure 3a illustrates how a perimeter-anchored hermetically sealed array of actuators can be used in a microfluidic device. The figure depicts a longitudinal cross-section of a microfluidic channel. The movable base 300 of the actuator, due to the deformations of the membranes of the electrostatic cells integrated on its upper surface (see Figure 1), creates a deflection in the upper wall of the microchannel 301. The microchannel 301 is mounted on the base 302. Selecting proper moments of time at which the actuator elements are excited, peristaltic pumping of the non-pressurized liquid is created in the selected direction 303. The actuator's element 300 has an appropriate number of electrostatic cells, which is optimized according to the scope of application and the dimensions of the microchannel. The width of the microchannel can be equipped with one or more such actuators, depending on the required microfluidic control characteristics.

Figure 3b shows (the top perspective view) a part of the microchannel 301 and a peristaltic pump installed in its upper wall, comprising four integrated actuators 300. These pump-actuators are excited in a certain order, so, that by locally and dynamically creating pressure to the non-compressible fluid in the microchannel 301, the chosen direction of the liquid flow 303 is created. The dimensions of the actuators 300 and number thereof within the width of the microchannel 301 are selected according to the intended characteristics of the microflow control.

Figure 3c shows the use of a single actuator 300 to perform the function of a microfluidic valve. The microfluidic device 305 has a branch to the valve and a baffle 304 narrowing the microchannel of this branch. Upon electrostatic excitation of the actuator 300, its curvature profile will coincide with the upper profile of the microchannel baffle 304, thus closing the flow of fluid in the branch. The dimensions of the actuators and the number of valves above the narrowing partition 304 can be selected various depending on the desired technical characteristics of the device.

**Method of fabrication of the actuator.** The described embodiments of the actuator can be produced by using CMOS-compatible micromachining processes.

The invention alse-covers the actuator fabrication technology based on wafer bonding and bulk micromachining processes, the essential steps of which are presented in Figure 5.

Fabrication of the actuator device begins with preparation of two silicon wafers as shown in Figure 5a. Figure 5a shows two prepared wafers: 400 - monocrystalline silicon wafer with under-membrane microstructures of capacitive cells 403 formed by thermal oxidation and lithography methods; 401 - monocrystalline silicon wafer with an insulated silicon layer 402 (SOI). The term "under-membrane structures" herein encompases the series of structural elements shown in Figure 1 (see Fig. 1): the anchoring support 126, the lower electrode 125, and the vertical support 123. These elements are formed by deep-etching down to the heavily doped monocrystalline silicon wafer 400. Supporting elements for bonding with the SOI wafer 401, i.e. the anchoring support 126 and the vertical support 123 according to Figure 1 are selectively oxidized using a local thermal oxidation process (LOCOS). Thereby, a layer providing electrical insulation is formed, the locations of which are marked by 405 (the layer itself is not shown, to keep the drawing simpler). The under-membrane elements can also be etched in the thermally grown silicon oxide layer, thus avoiding the step of selective oxidation of the supporting elements. In this case, the surface of the lower electrode 125 must be covered with an electrically conductive material, for example, a layer of doped polycrystalline silicon, before the wafer bonding step. The latter layer must be electrically connected with the wafer 400 array.

Figure 5b shows bonded wafers thinned to the required thickness. The wafers are thinned using chemical-mechanical polishing method (CMP), providing the high quality surface suitable for thin layer deposition and lithography. The object 404 is a protective silicon-nitride mask formed by chemical vapor deposition and lithography methods, prepared after bonding and thinning the wafers.

Then, removing the unmasked portions of the wafer by deep reactive ion etching exposes the electrostatic cell membranes 120 as shown in Figure 5c. The *burried oxide* located in the wafer 401 between the carrier wafer and the device layer 402 acts as an etch stop in the vertical direction during release. The parts of the wafer protected by the mask establish the stationary base 110 of the actuator. If necessary (e.g., dictated by the logic of the electrical connections), after the release of the membranes, their outer surface and the remaining silicon array forming the stationary base 101 can be coated with a thin film of silicon oxide, thus ensuring electrical isolation. Electrostatic cells are metallized by deposition and lithography, to form a thin metal film that acts as the top electrode and as the contact pads 109. The connection of the top electrode to the contact pads 109 is done by angled metal vapor deposition and/or using a deposition mask to produce a thin metal layer that would cover the side walls of the base 101. If the produced actuator will be used in an aggressive and/or electrically conductive environment, this technological step is followed by passivation of the outer side of the device (at the bottom, according to the figure) by plasma enhanced deposition of a thin film of silicon nitride. The inner side of the actuator, which contains the upper electrodes and contact pads, is not required to be passivated, because the construction of the actuator is hermetic, i.e. protected from the environment. After assembly of the actuator with the electronics board and/or microfluidic device, the electrical connections may be additionally protected from the environment.

Figure 5d shows an array of AFM tips 100 that can be formed on the underside (as shown in the figure) of the actuator by using additive fabrication technology. For example, the tips 100 can be formed by 3D-nanoprinting, by two-photon polymerization [7]. Also, tips can be formed on the wafer 400 during its thinning, by combining chemical and plasma etching methods with etching masks before or after the CMP process [8]. A number of AFM tips fabrication technologies [9] are known, which are not the subject of this invention, but most of them can be successfully applied in the embodiments of the present invention.

NON-PATENT LITERATURE

1. S. R. Manalis, S. C. Minne and C. F. Quate, "Atomic force microscopy for high-speed imaging using cantilevers with an integrated actuator and sensor", Appl. Phys. Lett., vol. 68, no. 6, pp. 871-873, February 1996.

2. S. C. Minne, G. Yaralioglu, S. R. Manalis, J. D. Adams, J. Zesch, A. Atalar, et al., "Automated parallel high-speed atomic force microscopy", Appl. Phys. Lett., vol. 72, no. 18, pp. 2340-2342, May 1998.

3. Cao, W., Alsharif, N., Huang, Z. et al. Massively parallel cantilever-free atomic force microscopy. Nat Commun 12, 393 (2021). https://doi.org/10.1038/s41467-020-20612-3

4. P. Vettiger et al., "The "Millipede"-More than thousand tips for future AFM storage," in IBM Journal of Research and Development, vol. 44, no. 3, pp. 323-340, May 2000, doi: 10.1147/rd.443.0323.

5. Seong, M., Somnath, S., Kim, H. J. & King, W. P. Parallel nanoimaging using an array of 30 heated microcantilevers. RSC Adv. 4, 24747-24754 (2014).

6. E. Haeggstrom, G. G. Yaralioglu, A. S. Ergun and P. T. Khuri-Yakub, "Capacitive micromachined ultrasonic transducer based integrated actuator for atomic force microscope cantilevers," Proceedings of the 2nd IEEE Conference on Nanotechnology, Washington, DC, USA, 2002, pp. 45-49, doi: 10.1109/NANO.2002.1032120.

7. Alsharif, N., Burkatovsky, A., Lissandrello, C., Jones, K. M., White, A. E., Brown, K. A., Design and Realization of 3D Printed AFM Probes. Small 2018, 14, 1800162. https://doi.org/10.1002/smll.201800162

8. Mizuki Ono, Dirk Lange, Oliver Brand, Christoph Hagleitner, Henry Baltes. (2002) A complementary-metal-oxide-semiconductor-field-effect-transistor-compatible atomic force microscopy tip fabrication process and integrated atomic force microscopy cantilevers fabricated with this process. Ultramicroscopy 91:1-4, 9-20.

9. Chang Liu. (2008) Parallel scanning probe arrays: their applications. Materials Today 11, 22-29. Online publication date: 1-Jan-2008.

10. Thomas Sulzbach, Wolfgang Engl, Reinhard Maier, Jörg Diebel, Dr. Denis Dontsov, Enrico Langlotz, Dr. Walter Schott. (2010) Cantilever arrays with integrated actuation and sensing for parallel SPM. Procedia Engineering 5, 621-624.

11. A. G. Onaran et. al. A new atomic force microscope probe with force sensing integrated readout and active tip. February 2006 Review of Scientific Instruments 77(2).

12. Conrad, H., Schenk, H., Kaiser, B. et al. A small-gap electrostatic micro-actuator for large deflections. Nat Commun 6, 10078 (2015). https://doi.org/10.1038/ncomms10078.

## Claims

1. An electrostatically excited microelectromechanical actuator comprising at least

    - an actuator membrane (120) with a first electrode (104),
    - a plate-shaped deformable element (110) with a second electrode (125), and

- supporting elements (123, 126) separating the deformable element (110) and the actuator membrane (120) with a vacuum gap (121) and combining them into an electrostatically excited two-layer structure,

**wherein** the supporting elements (123, 126) divide this structure into more than one hermetic cells, hermetically separated by closed lines of the supporting elements (123, 126), where a closed line of the supporting elements (123, 126) of each cell comprises at least two segments, wherein

o a first segment is an anchor supporting element (126) not changing due to deformations of the deformable element (124, 110) and/or the actuator membrane (120), during electrostatic attraction, and
◦ a second segment is the rest part of the supporting element (123), which deforms due to the deformations of the actuator membrane (120) occurring during electrostatic attraction, thereby creating in the cell a local torque (127), which deforms the deformable element (110) of the actuator.

2. The actuator according to claim 1, **wherein** said electrostatically excited double-layered multi-cell structure is a rectangular plate, which is hermetically attached to a stationary base (101) of the actuator.

3. The actuator according to any one of claims 1-2, **wherein** a single cell of the actuator has a closed rectangular, square, triangular, polygonal, round or irregular shape, and the supporting elements (123, 126) of the cell and their heights are selected according to predefined deformation properties of the cell and required vertical torque (127).

4. The actuator according to any one of claims 1-3, **wherein** the first electrode (104) is common to all capacitive cells of the actuator, and the second electrode (125) is either common to all cells of the actuator, or it comprises more than one electrically separate electrodes associated with more than one group of cells.

5. The actuator according to any one of claims 1-3, **wherein** the double-layered multi-cellular structure of the actuator comprises elements (103, 103") increasing elasticity of said double-layered multi-cellular structure, said elements are realized as surface recesses or grooves in the actuator membrane (120) at a perimeter-attachment line and/or in the deformable element (110) between adjacent cells.

6. The actuator according to any one of claims 1-3, **wherein** more than one adjacent cells of the actuator are formed in opposite directions of their asymmetric shapes, so that when they operate simultaneously to amplify the deformations of the deformable element (110).

7. The actuator according to any one of claims 1-3, **wherein** more than one cells of the actuator are formed in various directions of their asymmetric shapes, so that when they operate simultaneously, to create maximal or multidirectional deformations of the deformable element (124).

8. The actuator according to any one of claims 1 to 7, **wherein** at least one cell of the actuator internally comprises electro-optic signal-reading elements (108) for reading the deformation state of the deformable element (120, 110, 124).

9. The actuator according to any one of claims 1 to 8, **wherein** the actuator is used in atomic-force-microscopy, AFM, applications, wherein the actuator further comprises an AFM tip (100) attached at the center of the deformable element (110) of the multi-cell structure of the actuator.

10. The actuator according to claim 9, **wherein** in AFM applications more than one actuators with tips (100) are implemented as a one-dimensional array of AFM sensors, or as a two-dimensional matrix of AFM sensors.

11. The actuator according to any one of claims 1 to 8, **wherein** in microfluidic control applications, the actuator is implemented in microchannels (301) to perform functions of peristaltic fluid pumps (300) and valves (304, 300) of microchannels (301).

12. A method of fabrication of an actuator according to claim 1, compatible with CMOS MEMS micromachining processes, comprising at least the following steps:

1) preparing a first doped monocrystalline silicon wafer (400) with under-membrane structures (403) formed in a monocrystalline silicon or silicon oxide thin layer, using lithography and etching steps;
2) a second monocrystalline silicon wafer (401) is prepared with a silicon on isolator structure (402), which is heavily-doped and has the required thickness of the electrostatic cell membrane;

3) the first doped monocrystalline silicon wafer (400) and the second monocrystalline silicon wafer (401) are connected;

4) a protective silicon nitride mask (404) prepared by lithography and etching methods after wafer bonding, is deposited onto both sides of the bonded wafers;

5) after removing the portions of the wafer not protected by the mask, the membranes of the electrostatic cells (120) are released, and the portions of the wafer protected by the mask form elements of mechanical strength (101), after the processes of deep reactive ion etching and wet etching;

6) after releasing the membranes (120), the silicon bulk is coated with a thin layer of silicon oxide, thereby providing an electrical insulation;

7) the electrostatic cells are metallized, by depositing a thin metal film thereby establishing the functional first electrode (104);

8) individual contact pads 109 are formed.

13. The method according to claim 12, **wherein** an AFM tip (100) or the array of AFM tips are produced on the formed electrostatic actuator's movable base (110) by three-dimensional nanoprinting, or by forming the AFM tip on the doped monocrystalline silicon wafer (400) during a step of thinning said doped monocrystalline silicon wafer (400).

**Patentansprüche**

1. Elektrostatisch angeregter mikroelektromechanischer Aktuator, der mindestens Folgendes umfasst:

- eine Aktuatormembran (120) mit einer ersten Elektrode (104),
- ein plattenförmiges verformbares Element (110) mit einer zweiten Elektrode (125) und
- Stützelemente (123, 126), die das verformbare Element (110) und die Aktuatormembran (120) durch einen Vakuumspalt (121) trennen und diese zu einer elektrostatisch angeregten zweischichtigen Struktur verbinden,

wobei die Stützelemente (123, 126) diese Struktur in mehr als eine hermetische Zelle unterteilen, die durch geschlossene Linien der Stützelemente (123, 126) hermetisch voneinander getrennt sind, wobei eine geschlossene Linie der Stützelemente (123, 126) jeder Zelle mindestens zwei Segmente umfasst, wobei

∘ ein erstes Segment ein Ankerstützelement (126) ist, das sich nicht aufgrund von Verformungen des verformbaren Elements (124, 110) und/oder der Aktuatormembran (120) während einer elektrostatischen Anziehung verändert, und
∘ ein zweites Segment der restliche Teil des Stützelements (123) ist, der sich aufgrund der Verformungen der Aktuatormembran (120), die während der elektrostatischen Anziehung auftreten, verformt und dadurch in der Zelle ein lokales Drehmoment (127) schafft, welches das verformbare Element (110) des Aktuators verformt.

2. Aktuator nach Anspruch 1, wobei die elektrostatisch angeregte doppelschichtige mehrzellige Struktur eine rechteckige Platte ist, die hermetisch an einer stationären Basis (101) des Aktuators befestigt ist.

3. Aktuator nach einem der Ansprüche 1-2, wobei eine einzelne Zelle des Aktuators eine geschlossene rechteckige, quadratische, dreieckige, polygonale, runde oder unregelmäßige Form aufweist und die Stützelemente (123, 126) der Zelle und ihre Höhen gemäß vordefinierten Verformungseigenschaften der Zelle und einem erforderlichen vertikalen Drehmoment (127) ausgewählt werden.

4. Aktuator nach einem der Ansprüche 1-3, wobei die erste Elektrode (104) allen kapazitiven Zellen des Aktuators gemeinsam ist und die zweite Elektrode (125) entweder allen Zellen des Aktuators gemeinsam ist oder mehr als eine elektrisch getrennte Elektrode umfasst, die mehr als einer Gruppe von Zellen zugeordnet ist.

5. Aktuator nach einem der Ansprüche 1-3, wobei die doppelschichtige mehrzellige Struktur des Aktuators Elemente (103, 103'') umfasst, welche eine Elastizität der doppelschichtigen mehrzelligen Struktur erhöhen, wobei die Elemente als Oberflächenaussparungen oder Rillen in der Aktuatormembran (120) an einer Umfangsbefestigungslinie und/oder in dem verformbaren Element (110) zwischen benachbarten Zellen umgesetzt sind.

6. Aktuator nach einem der Ansprüche 1-3, wobei mehr als eine benachbarte Zelle des Aktuators in entgegengesetzte Richtungen ihrer asymmetrischen Formen gebildet sind, so dass, wenn sie gleichzeitig agieren, um die Verformungen des verformbaren Elements (110) zu verstärken.

7. Aktuator nach einem der Ansprüche 1-3, wobei mehr als eine Zelle des Aktuators in verschiedene Richtungen ihrer asymmetrischen Formen gebildet sind, so dass, wenn sie gleichzeitig agieren, um maximale oder multidirektionale Verformungen des verformbaren Elements (124) zu erzeugen.

8. Aktuator nach einem der Ansprüche 1 bis 7, wobei mindestens eine Zelle des Aktuators intern elektrooptische Signalleseelemente (108) zum Lesen des Verformungszustands des verformbaren Elements (120, 110, 124) umfasst.

9. Aktuator nach einem der Ansprüche 1 bis 8, wobei der Aktuator in Rasterkraftmikroskopie-Anwendungen, RKM-Anwendungen, verwendet wird, wobei der Aktuator ferner eine RKM-Spitze (100) umfasst, die in der Mitte des verformbaren Elements (110) der mehrzelligen Struktur des Aktuators befestigt ist.

10. Aktuator nach Anspruch 9, wobei in RKM-Anwendungen mehr als ein Aktuator mit Spitzen (100) als eine eindimensionale Anordnung von RKM-Sensoren oder als eine zweidimensionale Matrix von RKM-Sensoren implementiert ist.

11. Aktuator nach einem der Ansprüche 1 bis 8, wobei, in mikrofluidischen Steuerungsanwendungen, der Aktuator in Mikrokanälen (301) implementiert ist, um Funktionen von peristaltischen Fluidpumpen (300) und Ventilen (304, 300) von Mikrokanälen (301) durchzuführen.

12. Verfahren zur Fertigung eines Aktuators nach Anspruch 1, das mit CMOS-MEMS-Mikrobearbeitungsprozessen kompatibel ist und mindestens die folgenden Schritte umfasst:

    1) Herstellen eines ersten dotierten monokristallinen Siliziumwafers (400) mit Untermembranstrukturen (403), die in einer dünnen Schicht aus monokristallinem Silizium oder Siliziumoxid gebildet sind, unter Verwendung von Lithographie- und Ätzschritten;
    2) Herstellen eines zweiten monokristallinen Siliziumwafers (401) mit einer Silizium-auf-Isolator-Struktur (402), die stark dotiert ist und die erforderliche Dicke der elektrostatischen Zellmembran aufweist;
    3) Verbinden des ersten dotierten monokristallinen Siliziumwafers (400) und des zweiten monokristallinen Siliziumwafers (401);
    4) Abscheiden einer schützenden Siliziumnitridmaske (404), die nach dem Bonden der Wafer durch Lithographie- und Ätzverfahren hergestellt wird, auf beiden Seiten der gebondeten Wafer;
    5) nach Entfernen der Teile des Wafers, die nicht durch die Maske geschützt werden, Freigeben der Membranen der elektrostatischen Zellen (120) und, nach den Prozessen eines tiefen reaktiven Ionenätzens und eines Nassätzens, Bilden, durch die Teile des Wafers, die durch die Maske geschützt wurden, von Elementen mit mechanischer Festigkeit (101);
    6) nach dem Freigeben der Membranen (120), Beschichten der Siliziummasse mit einer dünnen Schicht Siliziumoxid, wodurch eine elektrische Isolierung bereitgestellt wird;
    7) Metallisieren der elektrostatischen Zellen durch Abscheiden eines dünnen Metallfilms, wodurch die funktionale erste Elektrode (104) aufgebaut wird;
    8) Bilden einzelner Kontaktstellen (109).

13. Verfahren nach Anspruch 12, wobei eine RKM-Spitze (100) oder die Anordnung von RKM-Spitzen auf der beweglichen Basis (110) des gebildeten elektrostatischen Aktuators während eines Schritts eines Dünnermachens des dotierten monokristallinen Siliziumwafers (400) durch dreidimensionales Nanodrucken oder durch Bilden der RKM-Spitze auf dem dotierten monokristallinen Siliziumwafer (400) produziert werden.

**Revendications**

1. Actionneur microélectromécanique à excitation électrostatique comprenant au moins

    - une membrane d'actionneur (120) avec la première électrode (104),
    - un élément déformable en forme de plaque (110) avec une seconde électrode (125), et
    - des éléments de support (123, 126) séparant l'élément déformable (110) et la membrane d'actionnement (120) par un espace vide (121) et les combinant en une structure à deux couches excitée électrostatiquement,

dans lequel les éléments de support (123, 126) divisent cette structure en plus d'une cellule hermétique, séparées hermétiquement par des lignes fermées des éléments de support (123, 126), où une ligne fermée des éléments de support (123, 126) de chaque cellule comprend au moins deux segments, dans lequel

○ un premier segment est un élément de support d'ancrage (126) qui ne change pas en raison des déformations de l'élément déformable (124, 110) et/ou de la membrane d'actionneur (120), pendant l'attraction électrostatique, et

○ un deuxième segment est la partie restante de l'élément de support (123), qui se déforme en raison des déformations de la membrane d'actionneur (120) se produisant lors de l'attraction électrostatique, créant ainsi dans la cellule un couple local (127), qui déforme l'élément déformable (110) de l'actionneur.

2. Actionneur selon la revendication 1, dans lequel ladite structure multicellulaire à deux couches excitées électrostatiquement est une plaque rectangulaire, qui est fixée hermétiquement à une base fixe (101) de l'actionneur.

3. Actionneur selon l'une quelconque des revendications 1 à 2, dans lequel une cellule unique de l'actionneur a une forme fermée rectangulaire, carrée, triangulaire, polygonale, ronde ou irrégulière, et les éléments de support (123, 126) de la cellule et leurs hauteurs sont sélectionnés en fonction de propriétés de déformation prédéfinies de la cellule et de couple vertical requis (127).

4. Actionneur selon l'une quelconque des revendications 1 à 3, dans lequel la première électrode (104) est commune à toutes les cellules capacitives de l'actionneur, et la seconde électrode (125) est soit commune à toutes les cellules de l'actionneur, soit elle comprend plus d'une électrode électriquement séparées associées à plus d'un groupe de cellules.

5. Actionneur selon l'une quelconque des revendications 1 à 3, dans lequel la structure multicellulaire à deux couches de l'actionneur comprend des éléments (103, 103'') augmentant l'élasticité de ladite structure multicellulaire à deux couches, lesdits éléments sont réalisés sous forme d'évidements ou de rainures de surface dans la membrane de l'actionneur (120) au niveau d'une ligne de fixation périphérique et/ou dans l'élément déformable (110) entre des cellules adjacentes.

6. Actionneur selon l'une quelconque des revendications 1 à 3, dans lequel plus d'une cellule adjacente de l'actionneur sont formées dans des directions opposées de leurs formes asymétriques, de sorte que lorsqu'elles fonctionnent simultanément, elles amplifient les déformations de l'élément déformable (110).

7. Actionneur selon l'une quelconque des revendications 1 à 3, dans lequel plus d'une cellule de l'actionneur sont formées dans différentes directions de leurs formes asymétriques, de sorte que lorsqu'elles fonctionnent simultanément, elles créent des déformations maximales ou multidirectionnelles de l'élément déformable (124).

8. Actionneur selon l'une quelconque des revendications 1 à 7, dans lequel au moins une cellule de l'actionneur comprend en interne des éléments de lecture de signal électro-optique (108) pour lire l'état de déformation de l'élément déformable (120, 110, 124).

9. Actionneur selon l'une quelconque des revendications 1 à 8, dans lequel l'actionneur est utilisé dans des applications de microscopie à force atomique, AFM, dans lequel l'actionneur comprend en outre une pointe AFM (100) fixée au centre de l'élément déformable (110) de la structure multicellulaire de l'actionneur.

10. Actionneur selon la revendication 9, dans lequel dans des applications AFM, plusieurs actionneurs avec pointes (100) sont mis en œuvre sous la forme d'un réseau unidimensionnel de capteurs AFM, ou sous la forme d'une matrice bidimensionnelle de capteurs AFM.

11. Actionneur selon l'une quelconque des revendications 1 à 8, dans lequel dans des applications de contrôle microfluidique, l'actionneur est mis en œuvre dans des microcanaux (301) pour exécuter des fonctions de pompes à fluide péristaltiques (300) et de vannes (304, 300) de microcanaux (301).

12. Procédé de fabrication d'un actionneur selon la revendication 1, compatible avec les procédés de micro-usinage CMOS MEMS, comprenant au moins les étapes consistant à :

1) préparer une première plaquette de silicium monocristallin dopé (400) avec des structures sous-membranaires (403) formées dans une couche mince de silicium monocristallin ou d'oxyde de silicium, en utilisant des étapes de lithographie et de gravure ;

2) une seconde plaquette de silicium monocristallin (401) est préparée avec une structure de silicium sur isolant (402), qui est fortement dopée et possède l'épaisseur requise de la membrane de la cellule électrostatique ;

3) la première plaquette de silicium monocristallin dopée (400) et la seconde plaquette de silicium monocristallin (401) sont connectées ;

4) un masque protecteur en nitrure de silicium (404) préparé par des méthodes de lithographie et de gravure après le collage des plaquettes, est déposé sur les deux faces des plaquettes collées ;

5) après avoir retiré les parties de la plaquette non protégées par le masque, les membranes des cellules électrostatiques (120) sont libérées, et les parties de la plaquette protégées par le masque forment des éléments de résistance mécanique (101), après les processus de gravure ionique réactive profonde et de gravure humide ;

6) après avoir libéré les membranes (120), la masse de silicium est recouverte d'une fine couche d'oxyde de silicium, assurant ainsi une isolation électrique ;

7) les cellules électrostatiques sont métallisées, en déposant un film métallique mince établissant ainsi la première électrode fonctionnelle (104) ;

8) des plots de contact individuels (109) sont formés.

13. Procédé selon la revendication 12, dans lequel la pointe AFM (100) ou le réseau de pointes AFM sont produits sur la base mobile (110) de l'actionneur électrostatique formé par nano-impression tridimensionnelle, ou en formant la pointe AFM sur la plaquette de silicium monocristallin dopée (400) pendant une étape d'amincissement de ladite plaquette de silicium monocristallin dopée (400).

Fig. 1.

**Fig. 2.**

301        300        303

a)

302

b)

300

301

304        300

c)

305

Fig. 4. Fig. 3

a)

b)

Fig. 4.

Fig. 5.

**Fig. 6.**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 4724318 A
- US 7395698 B2
- WO 2008052065 A2
- US 7797757 B2
- US 9164277 B2
- US 5982709 A, 1998
- US 2016023244 A1

### Non-patent literature cited in the description

- **S. R. MANALIS ; S. C. MINNE ; C. F. QUATE**. Atomic force microscopy for high-speed imaging using cantilevers with an integrated actuator and sensor. *Appl. Phys. Lett.*, February 1996, vol. 68 (6), 871-873
- **S. C. MINNE ; G. YARALIOGLU ; S. R. MANALIS ; J. D. ADAMS ; J. ZESCH ; A. ATALAR et al.** Automated parallel high-speed atomic force microscopy. *Appl. Phys. Lett.*, May 1998, vol. 72 (18), 2340-2342
- **CAO, W. ; ALSHARIF, N. ; HUANG, Z. et al.** Massively parallel cantilever-free atomic force microscopy.. *Nat Commun*, 2021, vol. 12, 393, https://doi.org/10.1038/s41467-020-20612-3
- **P. VETTIGER et al.** The "Millipede"-More than thousand tips for future AFM storage. *IBM Journal of Research and Development*, May 2000, vol. 44 (3), 323-340
- **SEONG, M. ; SOMNATH, S. ; KIM, H. J. ; KING, W. P.** Parallel nanoimaging using an array of 30 heated microcantilevers. *RSC Adv.*, 2014, vol. 4, 24747-24754
- **E. HAEGGSTROM ; G. G. YARALIOGLU ; A. S. ERGUN ; P. T. KHURI-YAKUB**. Capacitive micromachined ultrasonic transducer based integrated actuator for atomic force microscope cantilevers. *Proceedings of the 2nd IEEE Conference on Nanotechnology*, 2002, 45-49
- **ALSHARIF, N. ; BURKATOVSKY, A. ; LISSANDRELLO, C. ; JONES, K. M. ; WHITE, A. E. ; BROWN, K. A.** Design and Realization of 3D Printed AFM Probes. *Small*, 2018, vol. 14, 1800162, https://doi.org/10.1002/smll.201800162
- **MIZUKI ONO ; DIRK LANGE ; OLIVER BRAND ; CHRISTOPH HAGLEITNER ; HENRY BALTES**. A complementary-metal-oxide-semiconductor-field-effect-transistor-compatible atomic force microscopy tip fabrication process and integrated atomic force microscopy cantilevers fabricated with this process. *Ultramicroscopy*, 2002, vol. 91, 1-4, 9-20
- **CHANG LIU.** Parallel scanning probe arrays: their applications. *Materials Today*, 01 January 2008, vol. 11, 22-29
- **THOMAS SULZBACH ; WOLFGANG ENGL ; REINHARD MAIER ; JÖRG DIEBEL ; DR. DENIS DONTSOV ; ENRICO LANGLOTZ ; DR. WALTER SCHOTT.** Cantilever arrays with integrated actuation and sensing for parallel SPM. *Procedia Engineering*, 2010, vol. 5, 621-624
- **A. G. ONARAN**. A new atomic force microscope probe with force sensing integrated readout and active tip.. *Review of Scientific Instruments*, February 2006, vol. 77 (2)
- **CONRAD, H. ; SCHENK, H. ; KAISER, B. et al.** A small-gap electrostatic micro-actuator for large deflections.. *Nat Commun*, 2015, vol. 6, 10078, https://doi.org/10.1038/ncomms10078